# EUROPEAN PATENT APPLICATION

(11) **EP 0 776 034 A2**
(43) Date of publication of application: **28.05.1997**
(21) Application number: 96118687.1
(22) Date of filing: 21.11.1996
(51) Int. Cl.: H01L 21/336, H01L 21/265, H01L 21/8238

(54) **Method of manufacturing a CMOS**

(30) Priority: 21.11.1995 US 7430
(71) Applicant: TEXAS INSTRUMENTS INCORPORATED, Dallas Texas 75265 (US)
(72) Inventor: Rodder,Mark S, University Park ,TX 75225 (US)
(74) Representative: Schwepfinger, Karl-Heinz, Dipl.-Ing.

(57) **Abstract**

One embodiment of the instant invention is a method of fabricating a MOS device, the method comprising the steps of: providing a substrate (18), the substrate of a first conductivity type and having a surface; forming a conductive layer (22) insulatively disposed over the substrate; etching portions of the conductive layer so as to form a gate structure (26 and 28), the gate structure having a top and sides; forming an insulating layer (30) (preferably accomplished by subjecting the MOS device to a rapid thermal growth process -- preferably the rapid thermal growth process is subjecting the MOS device to approximately 950 to 1050°C for approximately 5 to 20 seconds in an oxidizing ambient) on at least the sides of the gate structure; implanting dopants at the surface of the substrate and aligned to the gate structure and the insulating layer on the sides of the gate structure so as to form source/drain extensions (34 and 40); and performing a rapid thermal anneal process so as to lessen implant damage and reduce transient enhanced diffusion of dopants during subsequent low-temperature process steps. Preferably, the rapid thermal anneal process comprises subjecting the MOS device to approximately 800 to 1000°C for approximately 5 to 45 seconds.

## Description

### FIELD OF THE INVENTION

The instant invention pertains to semiconductor device fabrication and processing and more specifically to rapid thermal anneal processing of MOS devices.

### BACKGROUND OF THE INVENTION

As MOS technology is scaled to sub-quarter micron gate lengths, rapid thermal processing (RTP) has become increasingly important. One type of RTP is rapid thermal anneal (RTA) which can be utilized so as to achieve low-resistivity doped regions which were formed by implantation and which diffuse a minimal amount during this high temperature, short duration thermal anneal step. Typically, such a high-temperature, short duration anneal step is performed after implanting the highly doped source/drain regions after sidewall formation but prior to the formation of any silicides. Additionally, RTA is performed after implantation of arsenic for source/drain and drain extension implants for dopant activation and reduction of inverse-short-channel effects for nMOS devices. Reduction of inverse-short-channel effects results from the high-temperature removal of implant induced interstitials such that interstitial enhanced diffusion of channel dopants (namely, boron in nMOSFETs) is diminished. In addition, RTA is performed after implantation of arsenic for source/drain and drain extension implants for reduction of diffusion at high arsenic doses, which are required for low parasitic source/drain resistance in advanced MOSFET structures.

While it is typical to utilize RTP with regards to nMOS devices, it is not known to use RTA with regards to pMOS devices. In view of this, it is an object of the instant invention to reduce enhanced diffusion for pMOS highly doped drain (HDD) structures formed with boron or a combination of boron and fluoride during subsequent low temperature steps. Additionally, it is an object of this invention to reduce diffusion of boron species from a pMOSFET gate through a gate insulator while at the same time removing gate etch lateral non-uniformity.

### SUMMARY OF THE INVENTION

In an embodiment of the instant invention, RTA is utilized for a pMOS structure which has highly doped drain extensions (HDD regions) so as to remove interstitial enhanced boron tail diffusion during subsequent low temperature process steps (such as low temperature sidewall formation process steps). Such a tail diffusion results in increased channel counter-doping and graded junctions, both of which result in poor pMOS performance (lower drive current and increased roll-off of Vₜ with decreasing gate length). In an additional embodiment of the instant invention, RTA is utilized for a pMOS structure which has gate dopants so as to remove gate-etch lateral non-uniformity during a subsequent gate etch, but the method of this embodiment would not cause enhanced diffusion of gate dopants from the gate through an underlying insulating layer.

An embodiment of the instant invention is a method of simultaneously fabricating a pMOS device and an nMOS device, the method comprising the steps of: providing a substrate of a first conductivity type and having a surface, the substrate having a pMOS device region and an nMOS device region; forming a conductive layer insulatively disposed over the substrate; doping a portion of the conductive layer that corresponds with the pMOS device with a dopant of the first conductivity type and doping a portion of the conductive layer that corresponds to the nMOS device with a dopant of a second conductivity type opposite the first conductivity type; performing a first rapid thermal anneal process so as to redistribute the dopants without the dopants substantially penetrating into the substrate or intermingling; etching portions of the conductive layer so as to form a gate structure for the pMOS device and a gate structure for the nMOS device, each of the gate structures having a top and sides; forming a first insulating layer on the top and sides of each of the gate structures; implanting dopants of the second conductivity type at the surface of the substrate in the nMOS device region and aligned to the first insulating layer situated on the nMOS gate structure so as to form source/drain extensions for the nMOS device; performing a second rapid thermal anneal process; forming a second insulating layer on the first insulating layer; implanting dopants of the first conductivity type at the surface of the substrate in the pMOS device region and aligned to the second insulating layer situated on the pMOS gate structure so as to form source/drain extensions for the pMOS device; and performing a third rapid thermal anneal process so as to lessen implant damage and reduce transient enhanced diffusion of the dopants during subsequent low-temperature process steps.

Preferably, the first rapid thermal anneal process comprises subjecting the MOS device to approximately 900 to 1000°C for approximately 5 to 60 seconds. The step of forming the first insulating layer is preferably comprised of subjecting the pMOS device and the nMOS device to a rapid thermal growth process which includes subjecting the pMOS and nMOS device to approximately 950 to 1050°C for approximately 10 to 30 seconds in an oxidizing ambient. The second rapid thermal anneal process is preferably accomplished by subjecting the MOS device to approximately 900 to 1000°C for approximately 10 to 30 seconds. Whereas the third rapid thermal anneal process is preferably accomplished by subjecting the MOS device to approximately 800 to 1000°C for approximately 5 to 45 seconds. Preferably, the first conductivity type is p-type, and the second conductivity type is n-type.

Another embodiment of the instant invention is a method of fabricating a MOS device, the method comprising the steps of: providing a substrate, the substrate of a first conductivity type and having a surface; forming a conductive layer insulatively disposed over the substrate; doping a portion of the conductive layer; performing a first rapid thermal anneal process so as to redistribute the dopant without the dopant substantially penetrating into the substrate; etching portions of the conductive layer so as to form a gate structure, the gate structure having a top and sides; forming an insulating layer on the top and sides of the gate structure by subjecting the MOS device to a rapid thermal growth process; implanting dopants at the surface of the substrate and aligned to the gate structure so as to form source/drain extensions; and performing a second rapid thermal anneal process so as to lessen implant damage and reduce transient enhanced diffusion of dopants during subsequent low-temperature process steps. Preferably, the first rapid thermal anneal process is subjecting the MOS device to approximately 900 to 1000°C for approximately 5 to 60 seconds.

Another embodiment of the instant invention is a method of simultaneously fabricating a pMOS device and an nMOS device, the method comprising the steps of: providing a substrate of a first conductivity type and having a surface, the substrate having a pMOS device region and an nMOS device region; forming a conductive layer insulatively disposed over the substrate; doping a portion of the conductive layer that corresponds with the pMOS device with a dopant of the first conductivity type and doping a portion of the conductive layer that corresponds to the nMOS device with a dopant of a second conductivity type opposite the first conductivity type; performing a first rapid thermal anneal process so as to redistribute the dopants without the dopants substantially penetrating into the substrate or intermingling; etching portions of the conductive layer so as to form a gate structure for the pMOS device and a gate structure for the nMOS device, each of the gate structures having a top and sides; forming a first insulating layer on the top and sides of each of the gate structures; implanting dopants of the second conductivity type at the surface of the substrate in the nMOS device region and aligned to the first insulating layer situated on the nMOS gate structure so as to form source/drain extensions for the nMOS device; implanting dopants of the first conductivity type at the surface of the substrate in the pMOS device region and aligned to the first insulating layer situated on the pMOS gate structure so as to form source/drain extensions for the pMOS device; and performing a second rapid thermal anneal process so as to lessen implant damage and reduce transient enhanced diffusion of the dopants during subsequent low-temperature process steps. Preferably, the step of forming the first insulating layer is comprised of subjecting the pMOS device and the nMOS device to a rapid thermal growth process.

### BRIEF DESCRIPTION OF THE DRAWINGS

The present invention will now be further described, by way of example, with reference to illustrated embodiments shown in the accompanying drawings:
FIGUREs 1-7 are cross-sectional views of two semiconductor devices of the instant invention which are fabricated using the process of the instant invention, that illustrate the successive stages of fabrication of these two devices;
FIGURE 8 is a graph illustrating the effect of an arsenic HDD anneal on Vₜ roll-off;
FIGURE 9 is a graph illustrating pMOS Vₜ roll-off versus gate length for 0.18 µm process with RTA HDD and source/drain anneal compared to a prior furnace process flow;
FIGURE 10 is a graph illustrating a SIMS profile depicting the elimination of interstitials enhanced transient diffusion of a boron tail region with an RTA process step preceding a low-temperature sidewall deposition step; and
FIGURE 11 is a graph illustrating the gate to drain capacitacne versus gate to drain bias (with V_{G} equal to 0 volts) that shows the abrupt p-type source/drain juction profie with RTA HDD anneal prior to sidewall deposition.

### DETAILED DESCRIPTION OF THE DRAWINGS

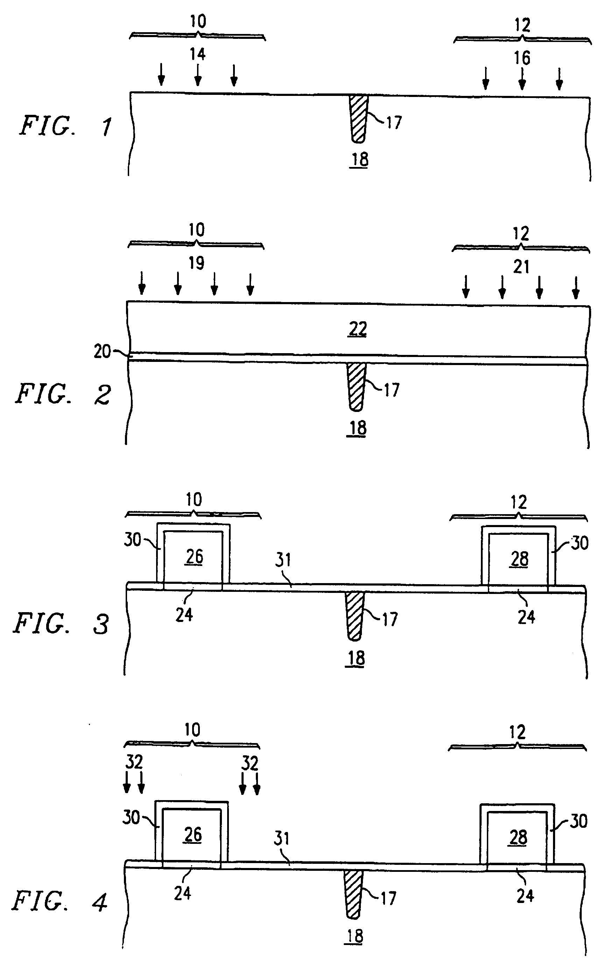

FIGUREs 1-7 illustrate the successive stages of fabrication of nMOS device 10 and pMOS device 12 using an embodiment of the instant invention. Similar reference numerals are utilized in these figures to illustrate similar structures.

In the process steps illustrated in FIGURE 1, implants are performed into substrate 18 so as to form well regions (not shown). After the well regions are formed, trench isolation regions 17 are formed so as to electrically isolate nMOS device 10 from pMOS device 12. After trench isolation regions 17 are formed, dopants are implanted into substrate 18 so as to form Vₜ implants. These implants are depicted as implants 14 for nMOS device 10 and implants 16 for pMOS 12. The Vₜ implants provide the desired near-surface doping profiles.

Referring to FIGURE 2, insulating layer 20 is grown. Preferably, insulating layer 20 is a 10 to 60Å thick dielectric (preferably oxide). After insulating layer 20 is grown, conductive layer 22 is formed on insulating layer 20. Preferably, conductive layer 22 is a 1000 to 2500Å thick polysilicon layer or any other conductive layer that can be utilized to form conductive gate structures. N-type dopants 19 are implanted (preferably at a dose of approximately 10¹⁵ to 10¹⁶ cm⁻²) into nMOS region 10 of conductive layer 22 and p-type dopants are implanted (preferably at a dose of approximately 10¹⁵ to 10¹⁶ cm⁻²) into pMOS region 12 of conductive layer 22. Typically, prior to etching the gate structures, these dopants would be annealed by subjecting the wafer to approximately 850°C for 20 to 60 minutes. The result of this anneal would be to distribute the dopants and/or remove implant damage. In an embodiment of the instant invention, these dopants would be annealed (prior to etching conductive layer 22 to form gate structures 26 and 28) at approximately 900 to 1000°C (preferably around 950°C) for 10 to 30 seconds. This type of rapid thermal annealing will redistribute the dopants and repair implant damage, but it will not cause the dopants to penetrate from conductive layer 22 through insulating layer 20 and into substrate 18.

Referring to FIGURE 3, portions of conductive layer 22 are removed so as to leave gate structure 26 for nMOS device 10 and gate structure 28 for pMOS device 12. As a result of the removal of portions of conductive layer 22, the portions of insulating layer 20 that underlie the portions of conductive layer 22 that were removed will be thinner than the portions of insulating layer that remain under gate structures 26 and 28 (i.e. gate insulators 24). The reason for this is that during the removal of the portions of conductive layer 22, the etchant used to remove these portions will also remove the top portion of exposed insulating layer 20.

After gate structures 26 and 28 are formed, a thin insulator (preferably 20 to 60Å of thermally grown oxide) is formed on gate structures 26 and 28 and on the exposed portions of insulating layer 20. The result of this is to form thin insulator 30 on gate structures 26 and 28 and to thicken the exposed portions of insulating layer 20 (thereby forming insulating layer 31). Typically, this thin layer of oxide would be grown by subjecting the wafer to an 850°C oxygen ambient for 5 to 20 minutes so as to form 20 to 60Å oxide film. In one embodiment of the instant invention, a 20 to 40Å oxide can be grown by subjecting the wafer to an 800°C oxygen ambient for 5 to 20 minutes. In another embodiment of the instant invention, a thin oxide layer could be grown by subjecting the wafer to a oxygen ambient of 950 to 1050°C for 10 to 30 seconds (preferably 1000°C for 15 seconds).

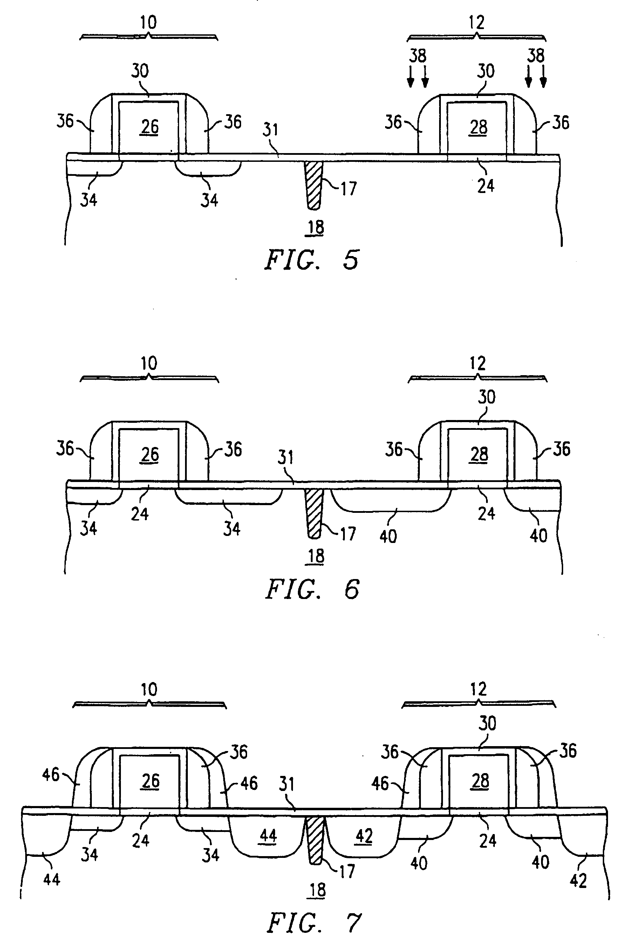

Referring to FIGURE 4, after masking off pMOS device 12, highly doped regions are formed in nMOS device 10 by implanting dopants 32. Preferably the dopants are comprised of As, Sb, As and B, Sb and B, As and In, or Sb and In. In addition, the n-type dopants (such as As or Sb) are preferably doped at a level between 4 x 10¹⁴ cm⁻² and 1.5 x 10¹⁵ cm⁻², at 10 to 20 keV. After implantation of the dopants, the wafer is preferably subject to an anneal process. This anneal process can either be accomplished by subjecting the wafer to: 900°C for 15 to 60 seconds; 950°C for 10 to 30 seconds; or 1000°C for 5 to 15 seconds. These highly doped regions are shown in FIGURE 5 as source/drain extensions 34.

Referring to FIGURE 5, after source/drain extensions 34 are formed a dielectric (preferably an oxide) is deposited and etched so as to form dielectric spacers 36. During the etching of the dielectric layer, some portion (maybe all) of insulating layer 31, which is not under spacers 36, may be etched. If this is the case, another dielectric layer may or may not be formed in its place.

Implantation of dopants 38 is performed next for pMOS device 12. Preferably, dopants 38 are comprised of BF_{2,} BF₂ and Sb, B and Sb, B and P, or B and Ge. The dopant level of dopants 38 is preferably on the order of 1 x 10¹⁴ cm⁻² and 1.5 x 10¹⁵ cm⁻² , and the implantation energy for boron comprising species is preferably between 5 and 20 keV. If BF₂ and Sb are utilized, dielectric spacers 36 may not have to be formed.

Referring to FIGURE 6, after the implantation of dopants 38 is performed, the dopants are annealed. Utilizing an embodiment of the instant invention, this can be achieved by subjecting the wafer to approximately 800-1000°C (preferably 900 to 950°C) for approximately 5 to 45 seconds. The result of this anneal is to slightly diffuse the dopants (thereby forming source/drain extensions 40) and to reduce transient enhanced diffusion of the dopants during subsequent low-temperature steps, such as sidewall insulator deposition steps.

Referring to FIGURE 7, an additional sidewall insulator is formed. Sidewall insulator 46 is preferably formed of either oxide, nitride, or a combination of the two. This can be accomplished by a 650°C TEOS oxide process step which results in the formation of 250Å oxide, followed by a 700°C nitride deposition step which results in the formation of approximately 500 to 1400Å of nitride. After sidewall insulators 46 are formed, dopants are implanted in nMOS device 10 and pMOS device 12 so as to form highly doped source/drain regions 44 and 42, respectively, to reduce device series-resistance. Different dopant processes are used to form regions 42 and 44, and regions 42 and 44 are preferably deeper then source/drain regions 40 and 34, respectively. This is accomplished by either using a higher dopant concentration or using higher implantation energy. A subsequent anneal is preferably performed at between 1000 and 1050°C for approximately 10 to 30 seconds.

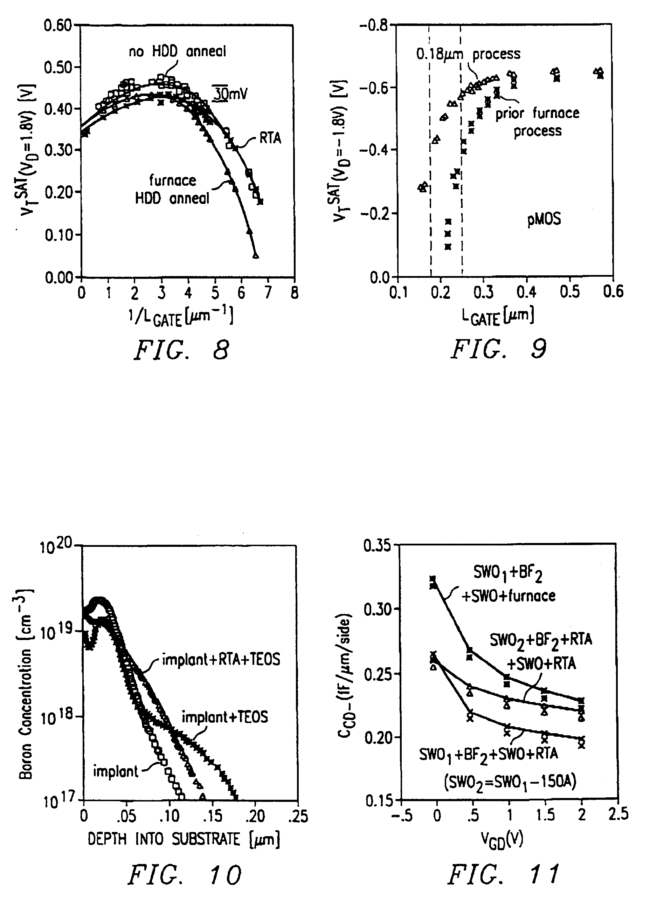

FIGUREs 8-11 illustrate several advantages of the various embodiments of the instant invention. FIGURE 8 illustrates the effect of an HDD/pocket anneal for devices with pocket implants and with a high HDD dose which is preferred for lower R_{sd} (preferably less than 280Ωµm). With a 900°C furnace anneal as is typically utilized, Vₜ roll-off is worse than it is if the method of the instant invention (labeled "RTA" in FIGURE 8) is used because of enhanced As HDD diffusion at higher As dopant concentrations.

FIGURE 9 illustrates the reduced Vₜ roll-off using the process of the instant invention (RTA HDD anneal and an RTA source/drain anneal) compared to at furnace anneal process (no pMOS HDD anneal and furnace source/drain anneal). FIGURE 10 shows that by utilizing the method of the instant invention (performing an RTA of the pMOS HDD prior to a low temperature dielectric deposition) the interstitial enhanced boron tail diffusion is eliminated. The boron tail diffusion due to the TEOS deposition of the prior art extends to a larger depth and is significantly more graded than the boron profile from diffusion when the method of the instant invention is utilized (RTA step precedes TEOS deposition). Referring to FIGURE 11, reduced tail diffusion results in more abrupt junctions from C_{gd} analysis thereby reducing channel counter-doping and, thus, reducing Vₜ roll-off.

Although specific embodiments of the present invention are herein described, they are not to be construed as limiting the scope of the invention. Many embodiments of the present invention will become apparent to those skilled in the art in light of methodology of the specification.

## Claims

1. A method for fabricating a MOS device, comprising:
forming a conductive layer insulatively disposed over a substrate;
etching portions of said conductive layer so as to form a gate structure,;
forming an insulating layer on at least a side of said gate structure;
implanting dopants at a surface of said substrate, said implanted dopants being aligned to said gate structure and said insulating layer on said sides of said gate structure so as to form source/drain extensions; and
performing a rapid thermal anneal process so as to lessen implant damage and reduce transient enhanced diffusion of dopants during subsequent low-temperature process steps.

2. The method of Claim 1, wherein said step of forming said insulating layer is accomplished by subjecting said MOS device to a rapid thermal growth process.

3. The method of Claim 2, wherein said step of performing said rapid thermal growth process comprises subjecting said MOS device to approximately 950 to 1050°C for approximately 5 to 20 seconds in an oxidizing ambient.

4. The method of any preceding claim, wherein said step of performing said rapid thermal anneal process comprises subjecting said MOS device to approximately 800 to 1000°C for approximately 5 to 45 seconds.

5. The method of any preceding claim, wherein said step of implanting depants so as to form source/drain extensions comprises forming source/drain extensions that are of a first conductivity type.

6. The method of any preceding claim, wherein the step of forming said conductive layer comprises forming the conductive layer over a substrate of a first conductivity type.

7. The method of Claim 6, wherein the step of forming said conductive layer on said substrate comprises forming the conductive layer on a substrate in which said first conductivity type is p-type.

8. A method for simultaneously fabricating a pMOS device and an nMOS device, said method comprising:
providing a substrate having a pMOS device region and an nMOS device region;
forming a conductive layer insulatively disposed over said substrate;
doping a portion of said conductive layer that corresponds with said pMOS device region with a dopant of a first conductivity type and doping a portion of said conductive layer that corresponds to said nMOS device region with a dopant of a second conductivity type;
performing a first rapid thermal anneal process so as to redistribute said dopants without the dopants substantially penetrating into said substrate or intermingling;
etching portions of said conductive layer so as to form a gate structure for said pMOS device and a gate structure for said nMOS device;
forming a first insulating layer on an upper region and side region of each of said gate structures;
implanting dopants of said second conductivity type at a surface of said substrate in said nMOS device region and aligned to said first insulating layer situated on said nMOS gate structure so as to form source/drain extensions for said nMOS device;
performing a second rapid thermal anneal process;
forming a second insulating layer on said first insulating layer;
implanting dopants of said first conductivity type at said surface of said substrate in said pMOS device region and aligned to said second insulating layer situated on said pMOS gate structure so as to form source/drain extensions for said pMOS device; and
performing a third rapid thermal anneal process so as to lessen implant damage and reduce transient enhanced diffusion of said dopants during subsequent low-temperature process steps.

9. The method of Claim 8, wherein said step of performing said first rapid thermal anneal process comprises subjecting said MOS device to approximately 900 to 1000°C for approximately 5 to 60 seconds.

10. The method of Claim 8 or Claim 9, wherein said step of forming said first insulating layer comprises subjecting said pMOS device and said nMOS device to a rapid thermal growth process which includes subjecting said pMOS and nMOS device to approximately 950 to 1050°C for approximately 10 to 30 seconds in an oxidizing ambient.

11. The method of Claims 8 to 10, wherein said step of performing said second rapid thermal anneal process comprises subjecting said MOS device to approximately 900 to 1000°C for approximately 10 to 30 seconds.

12. The method of any of Claims 8 to 11, wherein said step of performing said third rapid thermal anneal process comprises subjecting said MOS device to approximately 800 to 1000°C for approximately 5 to 45 seconds.

13. The method of any of Claims 8 to 12, wherein said step of providing said substrate comprises providing a substrate of a first conductivity type that is p-type.

14. The method of any of Claims 8 to 13, wherein said step of providing said substrate comprise providing a substrate of second conductivity type that is n-type.

15. A method for fabricating a MOS device, comprising:
forming a conductive layer insulatively disposed over a substrate;
doping a portion of said conductive layer;
performing a first rapid thermal anneal process so as to redistribute the dopant without the dopant substantially penetrating into said substrate;
etching portions of said conductive layer so as to form a gate structure;
forming an insulating layer on an upper region and a side region of said gate structure by subjecting said MOS device to a rapid thermal growth process;
implanting dopants at a surface of said substrate and aligned to said gate structure so as to form source/drain extensions; and
performing a second rapid thermal anneal process so as to lessen implant damage and reduce transient enhanced diffusion of dopants during subsequent low-temperature process steps.

16. The method of Claim 15, wherein said step of performing said first rapid thermal anneal process comprises subjecting said MOS device to approximately 900 to 1000°C for approximately 5 to 60 seconds.

17. A method for simultaneously fabricating a pMOS device and an nMOS device comprising:
providing a substrate having a pMOS device region and an nMOS device region;
forming a conductive layer insulatively disposed over said substrate;
doping a portion of said conductive layer that corresponds with said pMOS device region with a dopant of said first conductivity type and doping a portion of said conductive layer that corresponds to said nMOS device region with a dopant of a second conductivity type opposite said first conductivity type;
performing a first rapid thermal anneal process so as to redistribute said dopants without the dopants substantially penetrating into said substrate or intermingling;
etching portions of said conductive layer so as to form a gate structure for said pMOS device region and a gate structure for said nMOS device region;
forming a first insulating layer on an upper region and side region of each of said gate structures;
implanting dopants of said second conductivity type at a surface of said substrate in said nMOS device region and aligned to said first insulating layer situated on said nMOS gate structure so as to form source/drain extensions for said nMOS device;
implanting dopants of said first conductivity type at said surface of said substrate in said pMOS device region and aligned to said first insulating layer situated on said pMOS gate structure so as to form source/drain extensions for said pMOS device; and
performing a second rapid thermal anneal process so as to lessen implant damage and reduce transient enhanced diffusion of said dopants during subsequent low-temperature process steps.

18. The method of Claim 17, wherein said step of forming said first insulating layer is comprised of subjecting said pMOS device and said nMOS device to a rapid thermal growth process.
